# FASCICULE DE BREVET EUROPEEN

(11) **EP 1 752 857 B1**
(45) Date de publication et mention de la délivrance du brevet: **18.06.2008**
(21) Numéro de dépôt: 06118769.6
(22) Date de dépôt: 10.08.2006
(51) Int. Cl.: G06F 1/02, H03K 4/02

(54) **Générateur de signal de forme d'onde modifiable**
Generator von Signalen mit modifizierbarer Wellenform
Modifiable waveform signal generator

(30) Priorité: 11.08.2005 FR 0552495
(43) Date de publication de la demande: 14.02.2007
(73) Titulaire: ST MICROELECTRONICS S.A., 92120 Montrouge (FR)
(72) Inventeur: Cauchy Xavier, 38190 Laval (FR)
(74) Mandataire: de Beaumont, Michel

(56) Documents cités:
- US-A- 4 222 108

## Description

### Domaine de l'invention

La présente invention concerne un générateur d'un signal numérique ou analogique de forme d'onde modifiable.

### Exposé de l'art antérieur

Pour certaines applications, il est souhaitable de disposer d'un générateur de signal numérique ou analogique ayant une forme d'onde susceptible de pouvoir être modifiée selon les besoins. Un tel générateur peut être utilisé pour la fourniture des impulsions de synchronisation incluses dans un signal vidéo analogique et qui sont notamment utilisées pour commander le passage entre la fin de l'affichage d'une ligne d'une image et le début de l'affichage de la ligne suivante et le passage entre la fin de l'affichage d'une image et le début de l'affichage de l'image suivante. Un tel générateur peut également être utilisé pour la fourniture de messages numériques spécifiques destinés à être insérés dans un flux de données numériques, comme par exemple des signaux de fin de vidéo active ou de début de vidéo active, appelés signaux EAV ou SAV (acronymes anglais pour End of Active Video et Start of Active Video). De tels messages sont par exemple présents dans un flux de données vidéo numériques défini selon la norme ITUR-656.

Un premier exemple classique de générateur d'un signal numérique met en oeuvre une mémoire dans laquelle sont stockées toutes les valeurs du signal. Le signal est alors obtenu en lisant successivement les valeurs stockées dans la mémoire. Pour obtenir un signal analogique, il suffit alors de convertir le signal numérique obtenu par l'intermédiaire d'un convertisseur numérique-analogique. Si la mémoire est une mémoire vive ou mémoire RAM (acronyme anglais pour Random Access Memory), un tel générateur de signal peut fournir des signaux de forme quelconque en modifiant les valeurs stockées dans la mémoire. Un tel générateur de signal est généralement utilisé pour la fourniture de signaux de forme très simple, par exemple des signaux périodiques de période courte et est classiquement utilisé pour la fourniture d'un signal sinusoïdal. Toutefois, dès que le signal à fournir est relativement complexe, le nombre de valeurs à stocker dans la mémoire devient très important nécessitant l'utilisation d'une mémoire RAM de grandes dimensions à coût élevé.

Un second exemple classique de générateur de signal numérique met en oeuvre une machine à états, réalisée par exemple par un circuit dédié, chaque état correspondant à la fourniture d'une valeur du signal recherché. En rendant les transitions entre les états dépendant de paramètres modifiables, il est possible de changer la forme d'onde du signal obtenu. Une telle machine à états est par exemple utilisée pour la fourniture des impulsions de synchronisation de signaux vidéo analogiques qui ont des formes d'onde différentes selon les normes de signaux vidéo. Toutefois, la flexibilité d'une machine à états est limitée dans la mesure où tous les états et toutes les transitions entre états susceptibles d'intérêt doivent avoir été prévus avant la réalisation de la machine à états. Par exemple, les paramètres permettant de modifier les transitions entre états peuvent être déterminés pour permettre la fourniture de différents types d'impulsions de synchronisation selon les normes existantes. Toutefois, une nouvelle norme peut s'imposer qui demande des impulsions de synchronisation de forme différente qui ne pourront pas être obtenues avec la même machine à états. Par ailleurs, une machine à états correspond généralement à un circuit dédié complexe, dont la conception est délicate et dont le bon fonctionnement peut difficilement être vérifié de façon exhaustive.

Le document US 4 222 108 décrit un générateur d'un signal numérique.

### Résumé de l'invention

La présente invention vise un générateur d'un signal numérique (ou analogique après conversion numérique-analogique) de forme d'onde modifiable, de conception relativement simple et susceptible d'être réalisé au moins en partie sous forme intégrée avec un encombrement réduit.

Selon un autre objet de la présente invention, la fourniture de signaux de formes d'ondes différentes peut être obtenue sans modification de la structure du circuit formant le générateur.

Pour atteindre tout ou partie de ces objets, ainsi que d'autres, la présente invention prévoit un générateur d'un signal comprenant une mémoire dans laquelle sont stockées des instructions à des emplacements associés chacun à une adresse, chaque instruction comprenant une portion de code et une portion d'argument ; un moyen de fourniture successive d'adresses ; un moyen de lecture adapté à lire successivement les instructions stockées aux emplacements associés aux adresses fournies ; un moyen de décodage adapté à recevoir, pour chaque instruction lue, la portion de code de l'instruction et à fournir un signal d'activation qui dépend de la portion de code et adapté, pour chaque instruction lue, à fournir au moyen de fourniture successive d'adresses des signaux de commande qui dépendent de la portion de code de l'instruction lue, le moyen de fourniture successive d'adresses étant adapté à fournir l'adresse suivante en fonction des signaux de commande ; et un moyen de fourniture dudit signal adapté à recevoir, pour chaque instruction lue, la portion d'argument de l'instruction et adapté, en fonction du signal d'activation, à mémoriser la portion d'argument et à fournir ledit signal égal à la portion d'argument ou à fournir ledit signal égal à la portion d'argument précédemment mémorisée. La mémoire est une mémoire vive à accès unique et le moyen de fourniture successive d'adresses est adapté à fournir un signal d'autorisation d'écriture qui dépend des signaux de commande, le générateur comprenant un moyen de fourniture d'au moins une adresse d'écriture et d'une instruction à écrire et un moyen d'arbitrage adapté à recevoir le signal d'autorisation et l'adresse d'écriture et à autoriser une opération d'écriture de l'instruction à écrire dans la mémoire à l'emplacement associé à l'adresse d'écriture lorsque le signal d'autorisation est à une valeur déterminée, le moyen de décodage étant adapté à recevoir le signal d'autorisation et à ignorer la portion de code de l'instruction à écrire lorsque le signal d'autorisation est à la valeur déterminée.

Selon un exemple de réalisation de l'invention, le moyen de fourniture successive d'adresses est adapté à recevoir au moins un signal d'événement et, pour des signaux de commande déterminés, à fournir l'adresse suivante lorsque le signal d'événement est à une valeur déterminée.

Selon un exemple de réalisation de l'invention, le moyen de fourniture dudit signal comprend un multiplexeur commandé par le signal d'activation et adapté à recevoir à une première entrée la portion d'argument de l'instruction lue et à la seconde entrée ledit signal ; et une mémoire supplémentaire reliée à la sortie du multiplexeur et fournissant ledit signal.

La présente invention prévoit également un procédé de fourniture d'un signal par un générateur comprenant une mémoire dans laquelle sont stockées des instructions à des emplacements associés chacun à une adresse, chaque instruction comprenant une portion de code et une portion d'argument, le procédé comprenant une répétition des étapes consistant à fournir une adresse ; à lire l'instruction dans la mémoire à l'emplacement associé à l'adresse ; à fournir, pour chaque instruction lue, un signal d'activation qui dépend de la portion de code de l'instruction lue et des signaux de commande qui dépendent de la portion de code de l'instruction lue ; en fonction du signal d'activation, à mémoriser la portion d'argument de l'instruction lue et fournir ledit signal égal à la portion d'argument ou fournir ledit signal égal à la portion d'argument précédemment mémorisée ; et à déterminer l'adresse suivante à fournir en fonction des signaux de commande. Le procédé comprend en outre les étapes consistant à, pour chaque instruction lue, fournir un signal d'autorisation à partir de la portion de code de l'instruction lue ; à autoriser une opération d'écriture dans la mémoire d'une instruction à écrire lorsque le signal d'autorisation est à une valeur déterminée ; et à ignorer la portion de code de l'instruction à écrire lorsque le signal d'autorisation est à la valeur déterminée.

Selon un exemple de réalisation de l'invention, l'adresse est fournie à réception d'au moins un signal d'événement à une valeur déterminée.

### Brève description des dessins

Ces objets, caractéristiques et avantages, ainsi que d'autres de la présente invention seront exposés en détail dans la description suivante d'un exemple de réalisation particulier faite à titre non-limitatif en relation avec les figures jointes parmi lesquelles :
la figure 1 représente un exemple de signal susceptible d'être fourni par un générateur de signal selon la présente inv/ention ;
la figure 2 représente schématiquement un exemple de réalisation d'un générateur de signal selon l'invention ;
la figure 3 représente un exemple plus détaillé d'un élément du générateur de signal de la figure 2 ;
la figure 4 illustre les étapes d'un exemple de procédé de fourniture d'un signal par le générateur de signal selon l'invention ;
les figures 5 à 12 illustrent des étapes de procédés secondaires mis en oeuvre par le procédé de fourniture de signal par le générateur de signal selon l'invention ; et
les figures 13 à 17 représentent des exemples de circuits comprenant le générateur de signal selon l'invention.

### Description détaillée

Par souci de clarté, de mêmes éléments ont été désignés par de mêmes références aux différentes figures.

La présente invention consiste à prévoir un générateur de signal comprenant une mémoire dans laquelle est stockée, non pas la succession des valeurs du signal à fournir, mais une "description" de la façon de "tracer" le signal à fournir. Ceci est obtenu en utilisant un langage de programmation adapté à la description de signaux et comportant un nombre limité d'instructions.

Presque tous les signaux utilisés dans les circuits électroniques actuels comprennent des parties de valeur constante et des parties qui se répètent à plusieurs reprises. Le langage de programmation selon l'invention tient compte de telles caractéristiques et permet de décrire la plupart des signaux avec un nombre réduit d'instructions. Il comporte au moins des instructions permettant de :
spécifier une valeur numérique à fournir ;
maintenir la valeur numérique spécifiée pendant une durée déterminée ;
maintenir la valeur numérique spécifiée jusqu'à la survenue d'un événement déterminé ; et
répéter une partie du signal déjà fourni.

Un mode de réalisation de la présente invention prévoit de stocker en mémoire les instructions décrivant le signal à fournir sous la forme de données numériques de L+M bits, où les L bits de poids forts forment un signal op_code représentatif de l'instruction proprement dite et les M bits de poids faibles forment un signal arg qui est éventuellement utilisé par l'instruction.

Les instructions, et les actions qui en résultent, d'un exemple de langage de programmation selon l'invention vont maintenant être décrites. Pour chaque instruction, on a indiqué un identifiant (codé par le signal op_code) en majuscules.

L'instruction "SET arg" correspond à la fourniture d'un signal de sortie à la valeur arg. L'instruction "RPLSET arg" correspond, comme l'instruction SET, à la fourniture d'un signal de sortie à la valeur arg. De plus, l'adresse de cette instruction devient une adresse de référence pour une prochaine instruction REPLAY. L'instruction "RPTSET arg" correspond, comme l'instruction SET, à la fourniture d'un signal de sortie à la valeur arg. De plus, l'adresse de cette instruction devient une adresse de référence pour une prochaine instruction REPEAT. L'instruction "SKIP arg" correspond au maintien pendant arg cycles de fonctionnement de la valeur courante en sortie. L'instruction "STOP" correspond au maintien de la valeur courante en sortie jusqu'à la survenue d'un premier événement déterminé, correspondant par exemple à la réception d'un signal hsync. L'instruction "REPLAY arg" correspond à l'attente de la survenue du premier événement déterminé, correspondant par exemple à la réception du signal hsync, pour répéter arg fois la séquence d'instructions à partir de l'adresse de la dernière instruction RPLSET. L'instruction "REPEAT arg" correspond à la répétition, arg fois, de la séquence d'instructions à partir de l'adresse de la dernière instruction RPTSET. L'instruction "HOLD" correspond au maintien de la valeur courante en sortie jusqu'à la survenue d'un second événement déterminé, correspondant par exemple à la réception d'un signal vsync. L'instruction "JUMP arg" se présente toujours selon une paire d'instructions "JUMP arg1" et "JUMP arg2" successives. L'instruction "JUMP arg1" entraîne un saut vers l'instruction d'adresse arg1 et l'instruction "JUMP arg2" entraîne un retour à l'instruction qui suit l'instruction "JUMP arg2" lorsque l'instruction à l'adresse arg2 est atteinte. Pour un tel jeu d'instructions, le signal op_code peut être codé sur 4 bits (voire sur 3 bits en utilisant un bit du signal arg pour différencier deux signaux op-code identiques). Le signal arg est, par exemple, codé sur 10 bits. Selon l'instruction considérée, la totalité des bits du signal arg correspondant n'est pas nécessairement utilisée.

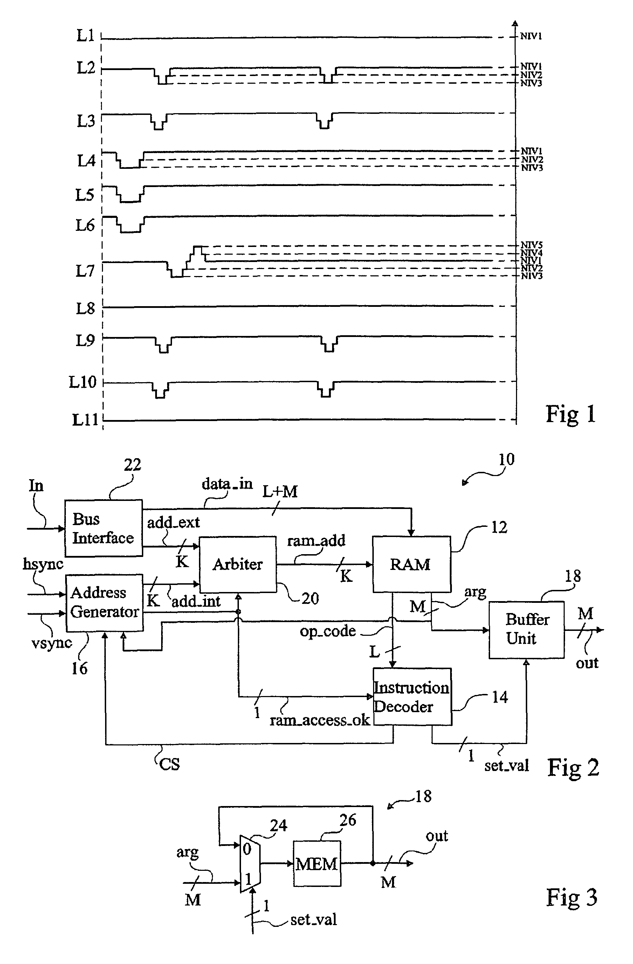

La figure 1 représente un exemple de signal susceptible d'être fourni par le générateur de signal selon l'invention. Il s'agit, par exemple, d'un signal de synchronisation vidéo associé à une image de 11 lignes L1 à L11. Le passage d'une ligne à une autre est associé à la réception d'un signal hsync par le générateur de signal et le passage de la dernière ligne d'une image à afficher à la première ligne de l'image suivante est associé à la réception d'un signal vsync par le générateur de signal.

Avec les instructions précédemment décrites, le programme permettant la fourniture du signal représenté en figure 1 est le suivant :

| Adresse de l'instruction en mémoire | Instruction | Ligne de l'écran | Description |
|---|---|---|---|
| Adresse1 | SET NIV1 | L1 | Met le signal à NIV1 |
| Adresse2 | STOP | L1 | Attend jusqu'au prochain signal hsync |
| Adresse3 | RPLSET NIV1 | L2 | Met le signal à NIV1 et fixe une référence pour la prochaine instruction REPLAY |
| Adresse4 | SKIP 28 | L2 | Maintient le signal à NIV1 pendant encore 29 cycles |
| Adresse5 | RPTSET NIV2 | L2 | Met le signal à NIV2 et fixe une référence pour la prochaine instruction REPEAT |
| Adresse6 | SET NIV3 | L2 | Met le signal à NIV3 |
| Adresse7 | SKIP 5 | L2 | Maintient le signal à NIV3 pendant encore 6 cycles |
| Adresse8 | SET NIV2 | L2 | Met le signal à NIV2 |
| Adresse9 | SET NIV1 | L2 | Met le signal à NIV1 |
| Adresse10 | SKIP 88 | L2 | Maintient le signal à NIV1 pendant encore 89 cycles |
| Adresse11 | REPEAT 1 | L2 | Répète une fois la séquence à partir de Adresse5 |
| Adresse12 | REPLAY 1 | L3 | Répète une fois la séquence à partir de Adresse3 à réception d'un signal hsync |
| Adresse13 | RPLSET NIV1 | L4 | Met le signal à NIV1 et fixe une référence pour la prochaine instruction REPLAY |
| Adresse14 | SKIP 8 | L4 | Maintient le signal à NIV1 pendant encore 9 cycles |
| Adresse15 | SET NIV2 | L4 | Met le signal à NIV2 |
| Adresse16 | SET NIV3 | L4 | Met le signal à NIV3 |
| Adresse17 | SKIP 10 | L4 | Maintient le signal à NIV3 pendant encore 10 cycles |
| Adresse18 | SET NIV2 | L4 | Met le signal à NIV2 |
| Adresse19 | SET NIV1 | L4 | Met le signal à NIV1 |
| Adresse20 | REPLAY 2 | L5-L6 | Répète la séquence à partir de Adresse13 à réception du signal hsync, pour les deux hsync suivants |
| Adresse21 | SET NIV1 | L7 | Met le signal à NIV1 |
| Adresse22 | SKIP 10 | L7 | Maintient le signal à NIV1 pendant encore 11 cycles |
| Adresse23 | SET NIV2 | L7 | Met le signal à NIV2 |
| Adresse24 | SET NIV3 | L7 | Met le signal à NIV3 |
| Adresse25 | SKIP 7 | L7 | Maintient le signal à NIV3 pendant encore 8 cycles |
| Adresse26 | SET NIV2 | L7 | Met le signal à NIV2 |
| Adresse27 | SET NIV1 | L7 | Met le signal à NIV1 |
| Adresse28 | SET NIV4 | L7 | Met le signal à NIV4 |
| Adresse29 | SET NIV5 | L7 | Met le signal à NIV5 |
| Adresse30 | SKIP 5 | L7 | Maintient le signal à NIV5 pendant encore 6 cycles |
| Adresse31 | SET NIV4 | L7 | Met le signal à NIV4 |
| Adresse32 | SET NIV1 | L7 | Met le signal à NIV1 |
| Adresse33 | STOP | L7 | Attend jusqu'au prochain signal hsync |
| Adresse34 | JUMP Adresse1 | L8-L10 | Renvoie vers l'instruction à Adresse1 |
| Adresse35 | JUMP Adresse11 | L8-L10 | Après l'instruction à Adresse11 retour à l'instruction à Adresse36 |
| Adresse36 | SET NIV1 | L11 | Met le signal à NIV1 |
| Adresse37 | HOLD | L11 | Attend jusqu'au prochain signal vsync |

La figure 2 représente un exemple de réalisation d'un générateur 10 selon l'invention adapté à fournir un signal numérique out ayant M bits. Le générateur 10 comprend une mémoire vive 12 (RAM), par exemple une mémoire vive à accès unique. La mémoire 12 comprend N emplacements, chaque emplacement étant associé à une adresse ram_add particulière codée sur K bits (N étant égal à la puissance Kième de 2). A titre d'exemple, pour le stockage de la séquence d'instructions précédemment décrites, K peut être égal à 6 bits. Dans chaque emplacement de la mémoire 12 peut être stockée une instruction sur M+L bits, correspondant par exemple à l'une des instructions précédemment décrites. Pour chaque instruction lue dans la mémoire 12 à une adresse donnée, les L bits de poids forts, formant le signal op_code, sont fournis à un module de décodage d'instruction 14 (Instruction Decoder) qui fournit des signaux de commande CS à un générateur d'adresse 16 (Address Generator). Simultanément, pour chaque instruction, les M bits de poids faibles, formant le signal arg, sont fournis au générateur d'adresse 16 et à un module tampon 18 (Buffer Unit) qui fournit le signal out. Le module tampon 18 est commandé par un signal set_val fourni par le module de décodage 14. Le générateur d'adresse 16 reçoit des signaux d'événement hsync et vsync et fournit à un module d'arbitrage 20 (Arbiter) un signal add_int représentatif d'une adresse de la mémoire 12.

L'écriture de données dans la mémoire 12 est réalisée par l'intermédiaire d'un module d'interface d'entrée 22 (Bus Interface) recevant un signal In et fournissant au module d'arbitrage 20 un signal add_ext représentatif d'une adresse de la mémoire 12 et un signal data_in correspondant à une instruction à stocker dans la mémoire 12. Le générateur d'adresse 16 fournit un signal ram_access_ok au module d'arbitrage 20 et au module de décodage 14 indiquant si une opération d'écriture peut être réalisée dans la mémoire. Le module d'arbitrage 20 fournit un signal d'adresse ram_add à la mémoire 12 qui correspond à l'un ou l'autre des signaux d'adresse add_ext ou add_int en fonction du signal ram_access_ok.

Le fonctionnement du générateur 10 selon l'invention est le suivant. La séquence d'instructions décrivant le signal à obtenir est stockée dans la mémoire 12 par l'intermédiaire du module d'interface 22. Pour la fourniture du signal recherché, le générateur d'adresse 16 fournit successivement des adresses de la mémoire 12. En fonction de chaque instruction lue, le module de décodage 14 permet ou non au module tampon 18 de modifier la valeur du signal out et commande le générateur d'adresse 16 pour la fourniture de la prochaine adresse de la mémoire 12. Plus particulièrement, si le signal op_code correspond à une instruction qui modifie la valeur du signal de sortie out (par exemple les instructions SET, RPTSET et RPLSET), alors le module de décodage 14 commande le module tampon 18, par l'intermédiaire du signal set_val, de façon que le signal out soit égal au signal arg reçu par le module tampon 18. Le module tampon 18 mémorise alors également le signal out. Si le signal op_code correspond à une instruction qui n'entraîne pas de modification de la valeur du signal de sortie out (par exemple les instructions SKIP, HOLD, STOP, JUMP, REPEAT et REPLAY), alors le module de décodage 14 commande le module tampon 18, par l'intermédiaire du signal set_val, de façon à ne pas tenir compte du signal arg qu'il reçoit. Le signal out est alors maintenu à la dernière valeur mémorisée par le module tampon 18.

La figure 3 représente un exemple de réalisation plus détaillé du module tampon 18. Le module tampon 18 comprend un multiplexeur 24, commandé par le signal set_val, dont une entrée reçoit le signal arg et dont l'autre entrée reçoit le signal out. La sortie du multiplexeur 24 est fournie à une mémoire 26 (MEM), par exemple réalisée par des bascules, qui fournit le signal out. Lorsque le signal set_val est, par exemple, à un état haut (correspondant à la valeur logique "1"), la sortie du multiplexeur 24 correspond au signal arg, et le signal out est égal au signal arg reçu par le multiplexeur 24. Lorsque le signal set_val est, par exemple, à un état bas (correspondant à la valeur logique "0"), la sortie du multiplexeur 24 correspond au signal out, c'est-à-dire au dernier signal stocké dans la mémoire 26.

Le générateur d'adresse 16 comporte trois compteurs appelés par la suite skip_counter, replay_counter et repeat_counter. En outre, le générateur d'adresse 16 comprend quatre mémoires appelées par la suite jump_to, jump_from, repeat_label et replay_label dans lesquelles sont stockées des adresses particulières de la mémoire 12. Le générateur de signal 10 comprend également une mémoire, non représentée, dans laquelle sont stockés des paramètres de fonctionnement du générateur de signal 10. Il s'agit, par exemple, de la taille des compteurs skip_counter, replay_counter et repeat_counter et des mémoires jump_to, jump_from, repeat_label et replay_label.

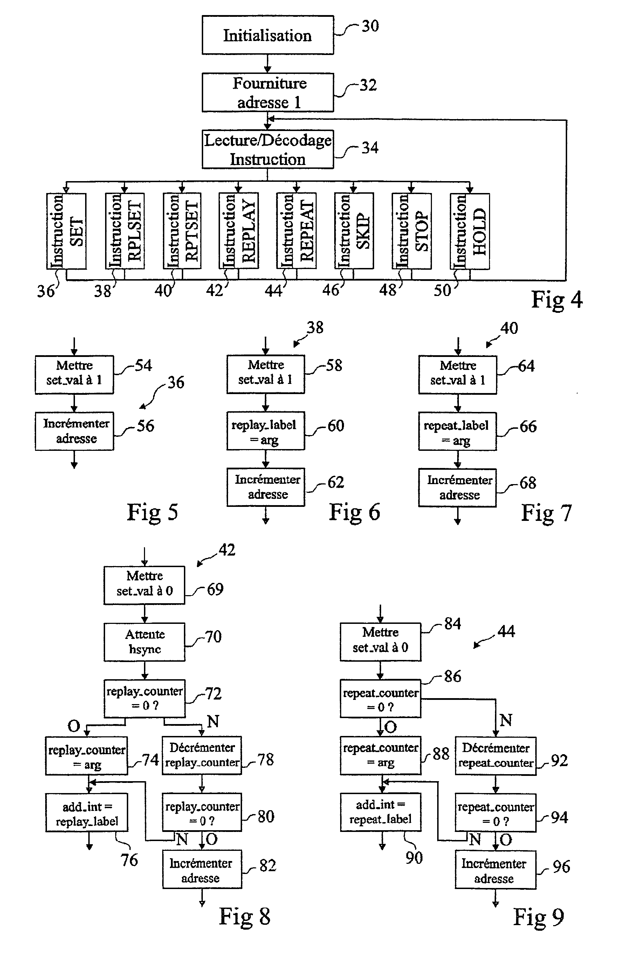

La figure 4 illustre les étapes d'un exemple de procédé de fourniture d'un signal par le générateur de signal 10 de la figure 1. Par la suite, on considère que le générateur d'adresse 16 incrémente l'adresse de lecture lorsqu'il fournit une nouvelle adresse de lecture qui désigne l'instruction qui suit normalement l'instruction stockée à l'adresse de lecture précédemment fournie dans la séquence d'instructions stockées dans la mémoire 12.

A l'étape 30, le générateur d'adresse 16 est initialisé. Les compteurs skip_counter, replay_counter et repeat_counter sont mis à zéro.

A l'étape 32, le générateur d'adresse 16 fournit au module d'arbitrage 20 un signal add_int correspondant à l'adresse de lecture de la mémoire 12 désignant la première instruction à lire de la séquence d'instructions stockée dans la mémoire 12.

A l'étape 34, le module d'arbitrage 20 commande une opération de lecture dans la mémoire 12 de l'instruction stockée à l'adresse de lecture fournie par le générateur d'adresse 16. Le signal op_code, c'est-à-dire les L bits de poids forts de l'instruction lue dans la mémoire 12 à l'adresse de lecture, est fourni au module de décodage 14. Selon que le signal op_code correspond à l'instruction SET, RPLSET, RPTSET, REPLAY, REPEAT, SKIP, STOP ou HOLD, les procédés secondaires 36, 38, 40, 42, 44, 46, 48 et 50 décrits ci-après sont effectués. Chacun de ces procédés secondaires aboutit à la fourniture d'une nouvelle adresse de lecture par le générateur d'adresse 16. Le procédé recommence alors à l'étape 34 jusqu'à ce que la dernière instruction de la séquence d'instructions stockée dans la mémoire 12 soit exécutée.

La figure 5 illustre les étapes du procédé secondaire 36 associé à l'instruction SET.

A l'étape 54, le module de décodage 14 met le signal set_val à 1. Le signal out fourni par le module tampon 18 correspond donc au signal arg de l'instruction lue dans la mémoire 12.

A l'étape 56, le générateur d'adresse 16 incrémente l'adresse de lecture et fournit un nouveau signal add_int au module d'arbitrage 20 et le procédé continue à l'étape 34.

La figure 6 illustre les étapes du procédé secondaire 38 associé à l'instruction RPLSET.

A l'étape 58, le module de décodage 14 met le signal set_val à 1. Le signal out fourni par le module tampon 18 correspond donc au signal arg de l'instruction lue dans la mémoire 12.

A l'étape 60, le générateur d'adresse 16 écrit dans la mémoire replay_label l'adresse de lecture en cours.

A l'étape 62, le générateur d'adresse 16 incrémente l'adresse de lecture et fournit un nouveau signal add_int au module d'arbitrage 20 et le procédé continue à l'étape 34.

La figure 7 illustre les étapes du procédé secondaire 40 associé à l'instruction RPTSET.

A l'étape 64, le module de décodage 14 met le signal set_val à 1. Le signal out fourni par le module tampon 18 correspond donc au signal arg de l'instruction lue dans la mémoire 12.

A l'étape 66, le générateur d'adresse 16 écrit dans la mémoire repeat_label l'adresse de lecture en cours.

A l'étape 68, le générateur d'adresse 16 incrémente l'adresse de lecture et fournit un nouveau signal add_int au module d'arbitrage 20 et le procédé continue à l'étape 34.

La figure 8 illustre les étapes du procédé secondaire 42 associé à l'instruction REPLAY.

A l'étape 69, le module de décodage 14 met le signal set_val à 0. Le signal out fourni par le module tampon 18 correspond donc au dernier signal arg mémorisé par le module tampon 18.

A l'étape 70, le générateur d'adresse 16 est inactif jusqu'à la réception du signal hsync. A la réception du signal hsync, le procédé continue à l'étape 72.

A l'étape 72, le générateur d'adresse 16 détermine si le compteur replay_counter est nul. Dans l'affirmative, le procédé continue à l'étape 74.

A l'étape 74, le générateur d'adresse 16 écrit le signal arg (ou seulement les bits "utiles" de celui-ci) dans le compteur replay_counter.

A l'étape 76, le générateur d'adresse 16 fournit un nouveau signal add_int au module d'arbitrage 20 égal au contenu de la mémoire replay_label. Le procédé continue à l'étape 34.

Si à l'étape 72, le compteur replay_counter n'est pas nul, le procédé continue à l'étape 78.

A l'étape 78, le générateur d'adresse 16 décrémente le contenu du compteur replay_counter.

A l'étape 80, le générateur d'adresse 16 détermine si le compteur replay_counter est nul. Dans la négative, le procédé continue à l'étape 76. Dans l'affirmative, le procédé continue à l'étape 82.

A l'étape 82, le générateur d'adresse 16 incrémente l'adresse de lecture et fournit un nouveau signal add_int au module d'arbitrage 20 et le procédé continue à l'étape 34.

La figure 9 illustre les étapes du procédé secondaire 44 associé à l'instruction REPEAT.

A l'étape 84, le module de décodage 14 met le signal set_val à 0. Le signal out fourni par le module tampon 18 correspond donc au dernier signal arg mémorisé par le module tampon 18.

A l'étape 86, le générateur d'adresse 16 détermine si le compteur repeat_counter est nul. Dans l'affirmative, le procédé continue à l'étape 88.

A l'étape 88, le générateur d'adresse 16 écrit le signal arg (ou seulement les bits "utiles" de celui-ci) dans le compteur repeat_counter.

A l'étape 90, le générateur d'adresse 16 fournit un nouveau signal add_int au module d'arbitrage 20 égal au contenu de la mémoire repeat_label. Le procédé continue à l'étape 34.

Si à l'étape 86, le compteur repeat_counter n'est pas nul, le procédé continue à l'étape 92.

A l'étape 92, le générateur d'adresse 16 décrémente le contenu du compteur repeat_counter.

A l'étape 94, le générateur d'adresse 16 détermine si le compteur repeat_counter est nul. Dans la négative, le procédé continue à l'étape 90. Dans l'affirmative, le procédé continue à l'étape 96.

A l'étape 96, le générateur d'adresse 16 incrémente l'adresse de lecture et fournit un nouveau signal add_int au module d'arbitrage 20 et le procédé continue à l'étape 34.

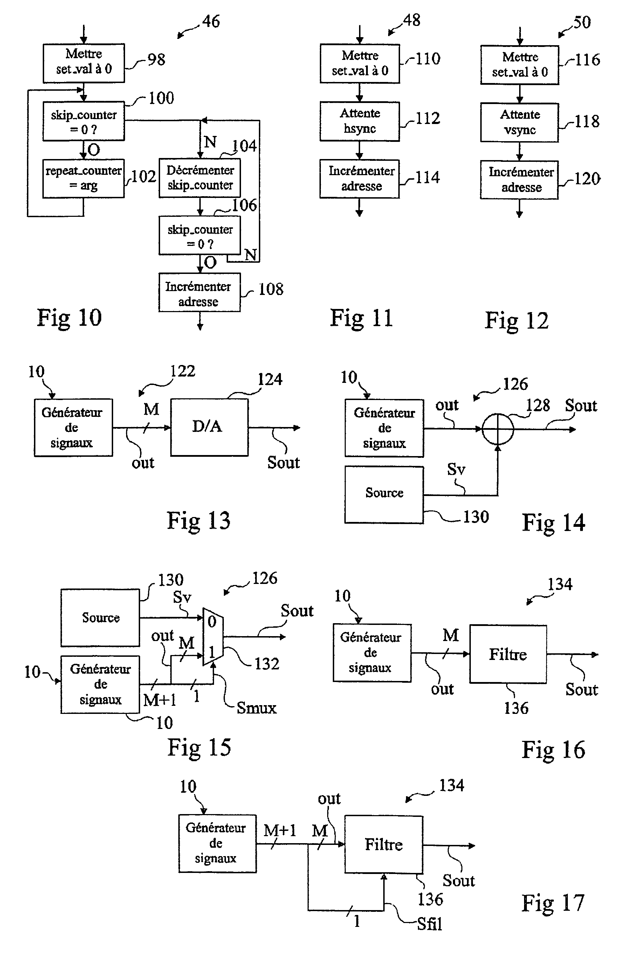

La figure 10 illustre les étapes du procédé secondaire 46 associé à l'instruction SKIP.

A l'étape 98, le module de décodage 14 met le signal set_val à 0. Le signal out fourni par le module tampon 18 correspond donc au dernier signal arg mémorisé par le module tampon 18.

A l'étape 100, le générateur d'adresse 16 détermine si le compteur skip_counter est nul. Dans l'affirmative, le procédé continue à l'étape 102.

A l'étape 102, le générateur d'adresse 16 écrit le signal arg (ou seulement les bits "utiles" de celui-ci) dans le compteur skip_counter. Le procédé continue à l'étape 100.

Si à l'étape 102, le compteur skip_counter n'est pas nul, le procédé continue à l'étape 104.

A l'étape 104, le générateur d'adresse 16 décrémente le contenu du compteur skip_counter.

A l'étape 106, le générateur d'adresse 16 détermine si le compteur skip_counter est nul. Dans la négative, le procédé continue à l'étape 104. Dans l'affirmative, le procédé continue à l'étape 108.

A l'étape 108, le générateur d'adresse 16 incrémente l'adresse de lecture et fournit un nouveau signal add_int au module d'arbitrage 20 et le procédé continue à l'étape 34.

La figure 11 illustre les étapes du procédé secondaire 48 associé à l'instruction STOP.

A l'étape 110, le module de décodage 14 met le signal set_val à 0. Le signal out fourni par le module tampon 18 correspond donc au dernier signal arg mémorisé par le module tampon 18.

A l'étape 112, le générateur d'adresse 16 est inactif jusqu'à la réception du signal hsync. A la réception du signal hsync, le procédé continue à l'étape 114.

A l'étape 114, le générateur d'adresse 16 incrémente l'adresse de lecture et fournit un nouveau signal add_int au module d'arbitrage 20 et le procédé continue à l'étape 34.

La figure 12 illustre les étapes du procédé secondaire 50 associé à l'instruction HOLD.

A l'étape 116, le module de décodage 14 met le signal set_val à 0. Le signal out fourni par le module tampon 18 correspond donc au dernier signal arg mémorisé par le module tampon 18.

A l'étape 118, le générateur d'adresse 16 est inactif jusqu'à la réception du signal vsync. A la réception du signal vsync, le procédé continue à l'étape 120.

A l'étape 120, le générateur d'adresse 16 incrémente l'adresse de lecture et fournit un nouveau signal add_int au module d'arbitrage 20 et le procédé continue à l'étape 34.

Le traitement d'une instruction JUMP est réalisé différemment. Le générateur de signal 10 comprend une machine à états qui, lorsque le signal out reste constant, c'est-à-dire lorsque le signal set_val est mis à 0 lors de l'exécution de l'un des procédés secondaires 46, 48 ou 50, parcourt les instructions stockées dans la mémoire 12 à la recherche de la prochaine instruction JUMP. Lorsqu'une instruction JUMP est détectée, la machine à états stocke dans la mémoire jump_from, l'adresse de lecture pour laquelle un saut doit être réalisé et dans la mémoire jump_to, l'adresse de lecture à destination de laquelle le saut doit être réalisé. Lorsque l'adresse de lecture fourni par l'exécution de l'un des procédés secondaires 36, 38, 40, 42, 44, 48 et 50 correspond à l'adresse de lecture stockée dans la mémoire jump_from, l'adresse de lecture est aussitôt remplacée par l'adresse de lecture stockée dans la mémoire jump_to. La machine à états recommence alors à balayer les instructions stockées dans la mémoire 12 pour rechercher la prochaine instruction JUMP.

La mémoire 12 utilisée peut être une mémoire RAM à accès unique (Single Port RAM). Il peut également s'agir d'une mémoire réalisée par des bascules. Cela signifie que les données data_in écrites dans la mémoire 12 se retrouvent systématiquement au niveau des signaux op_code et arg en sortie de la mémoire 12. De ce fait, des précautions doivent être prises si l'on souhaite réaliser des opérations d'écriture dans la mémoire 12 alors que le générateur de signal 10 est en fonctionnement. En effet, lors d'une opération d'écriture, les signaux op_code et arg fournis par la mémoire 12 ne correspondent pas à une instruction lue et ne doivent donc pas être pris en compte par le module de décodage 14 et par le générateur d'adresse 16. Pour ce faire, la présente invention prévoit l'utilisation du signal ram_access_ok. Lorsque le signal ram_access_ok est égal à la valeur logique "0", cela signifie que les opérations d'écriture dans la mémoire 12 ne sont pas autorisées. Le module d'arbitrage 20 ne tient alors pas compte d'éventuelles requêtes en écriture émises par le module d'interface 22. Lorsque le signal ram_access_ok est égal à la valeur logique "1", cela signifie que des opérations d'écriture dans la mémoire 12 sont autorisées. Le module d'arbitrage 20 peut alors accepter une éventuelle requête en écriture émise par le module d'interface 22 et fournir alors un signal ram_add correspondant au signal add_ext. Le générateur d'adresse 16 met le signal ram_access_ok à "1" lorsqu'il ne fournit pas de nouvelle adresse de lecture. C'est le cas, par exemple, lors de l'exécution d'une instruction SKIP tant que le compteur skip_counter n'atteint pas 0. Tant que le signal ram_access_ok est à "1", le module de décodage 14 ne tient pas compte du signal op_code fourni par la mémoire 12 et maintient les signaux CS et set_val à leurs dernières valeurs et le générateur d'adresse 16 ne tient pas compte du signal arg fourni par la mémoire 12. Dès que le générateur d'adresse 16 doit fournir une nouvelle adresse de lecture, il met le signal ram_access_ok à "0".

Les figures 13 à 17 illustrent différents circuits mettant en oeuvre le générateur de signal 10 selon l'invention.

La figure 13 représente un exemple de circuit 122 adapté à la fourniture d'un signal analogique Sout. Le circuit 122 comprend le générateur de signal 10 selon l'invention qui fournit le signal numérique out à un convertisseur numérique-analogique 124 (D/A). Le convertisseur 124 fournit un signal analogique Sout correspondant à la conversion du signal numérique out. Un tel montage permet donc la fourniture d'un signal analogique de forme quelconque.

La figure 14 représente un exemple de circuit 126 dans lequel le signal out fourni par le générateur de signal 10 selon l'invention est ajouté, par l'intermédiaire d'un additionneur 128, à un signal numérique Sv fourni par une source de signaux 130, par exemple une source de signaux vidéo. Le signal numérique Sout correspond alors à la somme des signaux out et Sv.

La figure 15 représente une variante du circuit 126 dans laquelle le signal Sv est fourni à une première entrée d'un multiplexeur 132 et le signal out est fourni à une seconde entrée du multiplexeur 132. Le multiplexeur 132 fournit le signal Sout qui est égal au signal Sv ou au signal out. Le multiplexeur 132 est commandé par un signal de commande Smux qui correspond par exemple au bit de poids le plus fort du signal out. Dans le présent exemple, le signal Sout est égal au signal out seulement lorsque le signal Smux correspond à la valeur logique "1". Le signal Smux peut correspondre à un bit additionnel ajouté au signal out et utilisé seulement pour la commande du multiplexeur 132.

La figure 16 représente un exemple de circuit 134 dans lequel le générateur de signal 10 selon l'invention fournit le signal numérique out à un filtre numérique 136 qui fournit le signal Sout. A titre d'exemple, le filtre numérique 136 est un filtre passe-bas. Un tel circuit est particulièrement avantageux lorsque l'on souhaite obtenir un signal Sout ayant des transitions "à échelons" entre deux paliers, qui après conversion numérique-analogique, devient un signal à pentes "douces". En effet, le filtre 136 permet d'obtenir de telles transitions "à échelons" lorsque le signal out correspond à un signal à fronts abrupts. Le nombre d'instructions à prévoir pour obtenir un tel signal out à fronts abrupts est alors réduit par rapport au nombre d'instructions qui serait nécessaire pour obtenir directement le signal out ayant des transitions à échelons. Ceci permet de diminuer la taille de la mémoire 12.

La figure 17 représente une variante du circuit de la figure 16 dans lequel le filtre 136 est activé par un signal Sfil qui correspond par exemple au bit du poids le plus fort du signal out. Lorsque le filtre 136 est désactivé, aucune opération de filtrage est réalisée et le signal Sout est égal au signal out. Le signal Sfil correspond alors à un bit additionnel ajouté au signal out et utilisé seulement pour la commande du filtre 136. Une telle variante permet de n'activer le filtre 136 qu'au niveau de certaines portions déterminées du signal out. Selon une autre variante, le filtre 136 est susceptible de réaliser deux opérations de filtrage différentes, la première lorsque le signal Sfil a la valeur logique "1" et la seconde lorsque le signal Sfil a la valeur logique "0".

La présente invention comporte de nombreux avantages :
premièrement, elle permet la fourniture de signaux numériques (ou analogiques après conversion) de formes d'onde quelconques, la seule limitation étant les dimensions de la mémoire dans laquelle sont stockées les instructions qui décrivent le signal souhaité ;
deuxièmement, elle permet de prendre en compte les redondances et les portions à niveau constant presque toujours présentes dans les signaux généralement utilisés en électronique, limitant ainsi le nombre d'instructions nécessaires à la description d'un signal et permettant de réduire les dimensions de la mémoire par rapport à une mémoire où serait stockée la totalité des valeurs du signal souhaité ; et
troisièmement, elle permet de modifier très facilement le signal fourni en modifiant seulement les instructions contenues dans la mémoire.

Bien entendu, la présente invention est susceptible de diverses variantes et modifications qui apparaîtront à l'homme de l'art. En particulier, les circuits représentés aux figures 13 à 17 peuvent être combinés. A titre d'exemple, le signal out fourni par le générateur de signal selon l'invention peut subir un filtrage numérique, puis être ajouté à un autre signal numérique, et enfin être converti en un signal analogique.

## Revendications

1. Générateur (10) d'un signal (out) comprenant :
une mémoire (12) dans laquelle sont stockées des instructions à des emplacements associés chacun à une adresse (ram_add), chaque instruction comprenant une portion de code (op_code) et une portion d'argument (arg) ;
un moyen (16) de fourniture successive d'adresses;
un moyen (20) de lecture adapté à lire successivement les instructions stockées aux emplacements associés aux adresses fournies ;
un moyen (14) de décodage adapté à recevoir, pour chaque instruction lue, la portion de code de l'instruction et à fournir un signal d'activation (set_val) qui dépend de la portion de code et adapté, pour chaque instruction lue, à fournir au moyen de fourniture successive d'adresses des signaux de commande qui dépendent de la portion de code (op_code) de l'instruction lue, le moyen de fourniture successive d'adresses étant adapté à fournir l'adresse suivante en fonction des signaux de commande ; et
un moyen (18) de fourniture dudit signal (out) adapté à recevoir, pour chaque instruction lue, la portion d'argument de l'instruction et adapté, en fonction du signal d'activation, à mémoriser la portion d'argument et à fournir ledit signal égal à la portion d'argument ou à fournir ledit signal égal à la portion d'argument précédemment mémorisée,
**caractérisé en ce que** la mémoire (12) est une mémoire vive à accès unique et **en ce que** le moyen (16) de fourniture successive d'adresses est adapté à fournir un signal (ram_access_ok) d'autorisation d'écriture qui dépend des signaux de commande, le générateur comprenant un moyen (22) de fourniture d'au moins une adresse d'écriture (add_ext) et d'une instruction (data_in) à écrire et un moyen d'arbitrage (20) adapté à recevoir le signal d'autorisation et l'adresse d'écriture et à autoriser une opération d'écriture de l'instruction à écrire dans la mémoire à l'emplacement associé à l'adresse d'écriture lorsque le signal d'autorisation est à une valeur déterminée, le moyen de décodage (14) étant adapté à recevoir le signal d'autorisation (ram_access_ok) et à ignorer la portion de code de l'instruction à écrire (data_in) lorsque le signal d'autorisation est à la valeur déterminée.

2. Générateur selon la revendication 1, dans lequel le moyen (16) de fourniture successive d'adresses est adapté à recevoir au moins un signal d'événement (hsync, vsync) et, pour des signaux de commande déterminés, à fournir l'adresse (add int) suivante lorsque le signal d'événement est à une valeur déterminée.

3. Générateur selon la revendication 1, dans lequel le moyen (18) de fourniture dudit signal (out) comprend :
un multiplexeur (24) commandé par le signal d'activation (set_val) et adapté à recevoir à une première entrée la portion d'argument (arg) de l'instruction lue et à la seconde entrée ledit signal ; et
une mémoire supplémentaire (26) reliée à la sortie du multiplexeur et fournissant ledit signal.

4. Procédé de fourniture d'un signal (out) par un générateur (10) comprenant une mémoire (12) dans laquelle sont stockées des instructions à des emplacements associés chacun à une adresse (ram_add), chaque instruction comprenant une portion de code (op_code) et une portion d'argument (arg), le procédé comprenant une répétition des étapes suivantes:
fournir une adresse ;
lire l'instruction dans la mémoire à l'emplacement associé à l'adresse ;
fournir, pour chaque instruction lue, un signal d'activation (set_val) qui dépend de la portion de code de l'instruction lue et des signaux de commande (CS) qui dépendent de la portion de code (op_code) de l'instruction lue ;
en fonction du signal d'activation, mémoriser la portion d'argument de l'instruction lue et fournir ledit signal égal à la portion d'argument ou fournir ledit signal égal à la portion d'argument précédemment mémorisée ; et
déterminer l'adresse suivante à fournir en fonction des signaux de commande,
**caractérisé en ce qu'**il comprend en outre les étapes suivantes, pour chaque instruction lue :
fournir un signal d'autorisation (ram_access_ok) à partir de la portion de code (op_code) de l'instruction lue ;
autoriser une opération d'écriture dans la mémoire (12) d'une instruction à écrire (data-in) lorsque le signal d'autorisation est à une valeur déterminée ; et
ignorer la portion de code de l'instruction à écrire (data_in) lorsque le signal d'autorisation est à la valeur déterminée.

5. Procédé selon la revendication 4, dans lequel l'adresse (add_int) est fournie à réception d'au moins un signal d'événement (hsync, vsync) à une valeur déterminée.

## Claims

1. A generator (10) of a signal (out) comprising:
a memory (12) in which instructions are stored at locations each associated with an address (ram_add), each instruction comprising a code portion (op_code) and an argument portion (arg);
means (16) for providing successive addresses;
means (20) for successively reading instructions stored at the locations associated with the provided addresses;
decoding means (14) capable of receiving, for each read instruction, the code portion of the instruction and of providing an activation signal (set_val) which depends on the code portion and capable, for each read instruction, of providing the means of successive address provision with control signals which depend on the code portion (op_code) of the read instruction, the successive address provision means being capable of providing the next address according to the control signals; and
means (18) for providing said signal (out) capable of receiving, for each read instruction, the argument portion of the instruction and capable, according to the activation signal, of storing the argument portion and of providing said signal equal to the argument portion or of providing said signal equal to the previously-stored argument portion;
**characterized in that** the memory (12) is a single-port RAM and the successive address provision means (16) are capable of providing a write authorization signal (ram_access_ok) which depends on the control signals, the generator comprising means (22) for providing at least one write address (add_ext) and one instruction (data_in) to be written and arbitration means (20) capable of receiving the authorization signal and the write address and of authorizing an operation of writing of the instruction to be written into the memory at the location associated with the write address when the authorization signal is at a determined value, the decoding means (14) being capable of receiving the authorization signal (ram_access_ok) and of ignoring the code portion of the instruction to be written (data_in) when the authorization signal is at the determined value.

2. The generator of claim 1, wherein the successive address provision means (16) are capable of receiving at least one event signal (hsync, vsync) and, for determined control signals, of providing the next address (add_int) when the event signal is at a determined value.

3. The generator of claim 1, wherein the means (18) for providing said signal (out) comprise:
a multiplexer (24) controlled by the activation signal (set_val) and capable of receiving, at a first input, the argument portion (arg) of the read instruction and, at the second input, said signal; and
an additional memory (26) connected to the output of the multiplexer and providing said signal.

4. A method of provision of a signal (out) by a generator (10) comprising a memory (12) in which are stored instructions at locations each associated with an address (ram_add), each instruction comprising a code portion (op_code) and an argument portion (arg), said method comprising a repetition of the steps of:
providing an address;
reading the instruction from the memory at the location associated with the address;
providing, for each read instruction, an activation signal (set_val) which depends on the code portion of the read instruction and control signals (CS) which depend on the code portion (op_code) of the read instruction;
according to the activation signal, storing the argument portion of the read instruction and providing said signal equal to the argument portion or providing said signal equal to the previously-stored argument portion; and
determining the next address to be provided according to the control signals,
**characterized in that** it further comprises the steps of, for each read instruction:
providing an authorization signal (ram_access_ok) based on the code portion (op_code) of the read instruction;
authorizing an operation of writing into the memory (12) of an instruction to be written (data_in) when the authorization signal is at a determined value; and
ignoring the code portion of the instruction to be written (data_in) when the authorization signal is at the determined value.

5. The method of claim 4, wherein the address (add_int) is provided on reception of at least one event signal (hsync, vsync) at a determined value.

## Patentansprüche

1. Ein Generator (10) eines Signals (out), der Folgendes aufweist:
Einen Speicher (12), in den Instruktionen an Stellen gespeichert werden, wobei jede mit einer Adresse (ram_add) assoziiert ist, wobei jede Instruktion einen Codeteil (op_code) und einen Argument-Teil (arg) aufweist;
Mittel (16) zum Vorsehen von aufeinander folgenden Adressen;
Mittel (20) zum aufeinander folgenden Lesen von Instruktionen, die an den Stellen assoziiert mit den vorgesehenen Adressen gespeichert sind;
Decodier-Mittel (14), die zum Empfangen des Codeteils der Instruktion in der Lage sind, und zwar für jede Leseinstruktion, und zum Vorsehen eines Aktivierungssignals (set_val) in der Lage sind, das von dem Codeteil abhängt und vor jede Leseinstruktion zum Vorsehen der Mittel der aufeinander folgenden Adresslieferung mit Steuersignalen in der Lage sind, die von dem Codeteil (op_code) der Leseinstruktion abhängt, wobei die Mittel zur aufeinander folgenden Adresslieferung in der Lage sind zum Vorsehen der nächsten Adresse gemäß der Steuersignale; und
Mittel (18) zum Vorsehen des Signals (out), die in der Lage sind, zum Empfangen, für jede Leseinstruktion des Argument-Teils der Instruktion und in der Lage sind gemäß dem Aktivierungssignal, zum Speichern des Argument-Teils und zum Vorsehen des Signals gleich dem Argument-Teil oder zum Vorsehen des Signals gleich dem vorher gespeicherten Argument-Teil;
**dadurch gekennzeichnet, dass** der Speicher (12) ein 1-Port-RAM ist, und die Mittel zur aufeinander folgenden Adresslieferung (16) in der Lage sind zum Vorsehen eines Schreib-Autorisierungs-Signals (ram_access_ok), das von den Steuersignalen abhängt, wobei der Generator Folgendes aufweist
Mittel (22) zum Vorsehen wenigstens einer Schreibadresse (add_ext) und eine Instruktion (data_in), die geschrieben werden soll und
Vermittlungs-Mittel (20), die in der Lage sind zum Empfangen des Autorisierungs-Signals und der Schreibadresse und zum Autorisieren einer Operation zum Schreiben der Instruktion, die in den Speicher an die Stelle assoziiert mit der Schreibadresse geschrieben werden soll, wenn das Autorisierungs-Signal einen bestimmten Wert hat, wobei die Decodier-Mittel (14) in der Lage sind zum Empfangen des Autorisierungs-Signals (ram_access_ok) und zum Ignorieren des Codeteils der Instruktion, der geschrieben werden soll (data_in), wenn das Autorisierungs-Signal den bestimmten Wert hat.

2. Generator nach Anspruch 1, wobei die Mittel zur aufeinander folgenden Adresslieferung (16) in der Lage sind zum Empfangen von wenigstens einem Ereignissignal (hsync, vsync) und, für bestimmte Steuersignale zum Vorsehen der nächsten Adresse (add_int), wenn das Ereignissignal einen bestimmten Wert hat.

3. Generator nach Anspruch 1, wobei die Mittel (18) zum Vorsehen des Signals (out) Folgendes aufweisen:
einen Multiplexer (24), der vom Aktivierungs-Signal (set_val) gesteuert wird und in der Lage ist zum Empfangen bei einer ersten Eingang des Argument-Teils (arg) der Leseinstruktion und, bei dem zweiten Eingang, das Signals; und
einen zusätzlichen Speicher (26), verbunden mit dem Ausgang des Multiplexers und zum Vorsehen des Signals.

4. Ein Verfahren zum Liefern eines Signals (out) durch einen Generator (10), der einen Speicher (12) aufweist, in dem Instruktionen an Stellen gespeichert sind, jede assoziiert mit einer Adresse (ram_add), wobei jede Instruktion einen Codeteil (op_code) und einen Argument-Teil (arg) aufweist, wobei das Verfahren eine Wiederholung der folgenden Schritte aufweist:
Vorsehen einer Adresse;
Lesen der Instruktion von dem Speicher an der Stelle assoziiert mit der Adresse;
Vorsehen, für jede Leseinstruktion, eines Aktivierungs-Signals (set_val), das von dem Codeteil der Leseinstruktion und den Steuersignalen (CS) abhängt, die von dem Codeteil (op_code) der Leseinstruktion abhängen;
Gemäß dem Aktivierungs-Signal, Speichern des Argument-Teils der Leseinstruktion und Vorsehen des Signals gleich dem Argument-Teil; oder Vorsehen des Signals gleich dem vorher gespeicherten Argument-Teil; und
Bestimmen der nächsten Adresse, die gemäß den Steuersignalen vorgesehen werden soll,
**dadurch gekennzeichnet, dass** es weiter für jede Leseinstruktion die folgenden Schritte aufweist:
Vorsehen eines Autorisierungs-Signals (ram_access_ok), basierend auf dem Codeteil (op_code) der Leseinstruktion;
Autorisieren einer Schreiboperation in den Speicher (12) einer Instruktion, die geschrieben werden soll (data_in), wenn das Autorisierungs-Signal einen bestimmten Wert hat; und
Ignorieren des Codeteils der Instruktion, die geschrieben werden soll (data_in), wenn das Autorisierungs-Signal einen bestimmten Wert hat.

5. Verfahren nach Anspruch 4, wobei die Adresse (add_int) vorgesehen wird, beim Empfang von wenigstens einem Ereignis-Signal (hsync, vsync) mit einem bestimmten Wert.
